# EUROPÄISCHE PATENTSCHRIFT

(11) **EP 2 715 288 B1**
(45) Veröffentlichungstag und Bekanntmachung des Hinweises auf die Patenterteilung: **08.07.2015**
(21) Anmeldenummer: 12721768.5
(22) Anmeldetag: 11.05.2012
(51) Int. Cl.: G01D 3/02, G01D 3/08

(54) **ELEKTRISCHE EINGABETASTE**
ELECTRIC INPUT KEY
TOUCHE D'ENTRÉE ÉLECTRIQUE

(30) Priorität: 25.05.2011 DE 102011103124
(43) Veröffentlichungstag der Anmeldung: 09.04.2014
(73) Patentinhaber: Audi AG, 85045 Ingolstadt (DE)
(72) Erfinder: MERKLEIN, Harald, 85139 Wettstetten (DE); BAUER, Martin, 85053 Ingolstadt (DE)
(74) Vertreter: Brandt, Kai
(86) Internationale Anmeldenummer: PCT/EP2012/002025
(87) Internationale Veröffentlichungsnummer: WO 2012/159712

(56) Entgegenhaltungen:
- DE-A1- 10 025 662
- DE-A1-102006 030 746
- DE-A1-102008 015 910
- JP-A- 2006 062 480
- US-A- 5 180 955
- US-A1- 2004 256 877
- US-A1- 2008 048 649

## Beschreibung

Die Erfindung betrifft eine elektrische Eingabetaste, mit einer Betätigungsfläche und mehreren Wegsensoren, die jeweils zur Erzeugung eines Wegsignals bei einer Berührung der Betätigungsfläche ausgebildet sind, sowie einer Auswerteeinheit zum Auswerten der Wegsignale und zum Ausgeben eines ermittelten Schaltzustands.

Derartige Eingabetasten werden beispielsweise bei Kraftfahrzeugen für die Eingabe von Schaltwünschen bei Shift-by-wire-Schaltbetätigungen verwendet. Die Wegsensorik der Eingabetaste kann redundant ausgeführt werden, indem mehrere Digitalsensoren, z. B. Mikroschalter, eingesetzt werden.

Aus der DE 10 2008 015 910 A1 ist eine elektrische Eingabetaste bekannt, bei deren Betätigung mehrere Schalter gleichzeitig schalten. Eine eventuelle Fehlfunktion kann mittels einer Diagnoseroutine festgestellt werden. Dazu wird ein Testsignal erzeugt, das an einen oder mehrere Schalter angelegt und von einer Steuereinheit ausgewertet wird.

Es sind auch elektrische Eingabetasten mit digitalen Wegsensoren bekannt, bei denen z. B. drei digitale Schalter verwendet werden. Ein bestimmter Schaltzustand bzw. ein Zustandswechsel wird durch das Signal von zwei der drei digitalen Schalter detektiert, so dass die Fehlfunktion eines einzelnen Digitalschalters ohne Auswirkungen bleibt. Derartige herkömmliche elektrische Eingabetasten mit mehrfachen, redundanten digitalen Wegsensoren, haben jedoch auch Nachteile. Aufgrund unvermeintlicher mechanischer Toleranzen haben die in einer Eingabetaste oder einer Schalteingabeeinheit verbauten Wegsensoren unterschiedliche Schaltpunkte. Wenn die Eingabetaste oder ein anderes Eingabeelement nur soweit betätigt wird, dass nicht alle Wegsensoren schalten, wird der noch nicht geschaltete Wegsensor fälschlicherweise als defekt diagnostiziert. Über die Lebensdauer kann es durch Verschleiß der mechanischen Komponenten zu Verschiebungen der Schaltpunkte der Wegsensoren kommen, die zu einer Vergrößerung der Schaltpunktdifferenzen zwischen den einzelnen Sensoren führen können. Dadurch kann es zu einer Zunahme der oben beschriebenen Fehldiagnosen einzelner Wegsensoren kommen.

Der Erfindung liegt daher die Aufgabe zugrunde, eine elektrische Eingabetaste anzugeben, die durch redundante Wegsensorik diagnosefähig ist und weitgehend unempfindlich gegenüber mechanischen Toleranzen und Verschiebungen von Schaltpunkten ist.

Zur Lösung dieser Aufgabe ist bei einer elektrischen Eingabetaste der eingangs genannten Art erfindungsgemäß vorgesehen, dass sie wenigstens einen analogen Wegsensor und wenigstens einen digitalen Wegsensor umfasst, sowie eine Kalibriereinrichtung zum Kalibrieren des analogen Wegsensors anhand von erfassten Wegsignalen des digitalen Wegsensors, wobei die Auswerteeinheit zur Durchführung einer Eigendiagnose anhand kalibrierter und erfasster Wegsignale ausgebildet ist. Alternativ kann der analoge Wegsensor auch anhand von erfassten Wegsignalen eines weiteren analogen Wegsensors kalibriert werden. Eine derartige Eingabetaste weist wenigstens zwei analoge Wegsensoren auf.

Die Erfindung beruht auf der Erkenntnis, dass eine besonders zuverlässige redundante elektrische Eingabetaste erhalten werden kann, wenn die Eingabetaste wenigstens einen analogen Wegsensor und wenigstens einen weiteren Wegsensor umfasst. Mittels einer Kalibriereinrichtung wird der analoge Wegsensor kalibriert, basierend auf erfassten Wegsignalen des weiteren Wegsensors, bei dem es sich um einen digitalen oder einen weiteren analogen Wegsensor handeln kann. Die Auswerteeinheit ist zur Durchführung einer Eigendiagnose ausgebildet, bei der kalibrierte Wegsignale und aktuelle, erfasste Wegsignale miteinander verglichen werden, um einen bestimmten Schaltzustand zu detektieren. Durch einen Vergleich der kalibrierten Wegsignale mit den erfassten Wegsignalen können Abweichungen und gegebenenfalls vorhandene Fehlfunktionen festgestellt werden.

Im Rahmen der Erfindung kann es vorgesehen sein, dass ein digitaler Wegsensor der elektrischen Eingabetaste als Mikroschalter oder als digitaler Hall-Sensor oder als digitaler magnetoresistiver Sensor ausgebildet ist. Digitale Wegsensoren in Form von Mikroschaltern weisen den Vorteil auf, dass sie kostengünstig sind und ein akustisch wahrnehmbares Signal beim Schalten erzeugen können.

Bei der erfindungsgemäßen elektrischen Eingabetaste kann der wenigstens eine analoge Wegsensor als induktiver Sensor oder als kapazitiver Sensor oder als analoger Hall-Sensor oder als analoger magnetoresistiver Sensor ausgebildet sein. Analoge Wegsensoren weisen den Vorteil auf, dass sie für jeden Punkt entlang ihres Betätigungswegs ein analoges Wegsignal liefern. Die erfindungsgemäße elektrische Eingabetaste umfasst wenigstens einen analogen Wegsensor, mit dem eine Kalibrierung durchgeführt wird, sowie wenigstens einen weiteren Wegsensor, der als digitaler oder analoger Wegsensor ausgebildet sein kann.

Das Wegsignal kann vorzugsweise eine Spannung sein, alternativ kann das Wegsignal jedoch auch ein Strom, eine Kapazität oder eine Magnetfeldstärke sein.

Eine Weiterbildung der Erfindung sieht vor, dass die Kalibriereinrichtung der elektrischen Eingabetaste zum Kalibrieren des analogen Wegsensors bei erstmaliger Berührung der Betätigungsfläche und/oder nach einer festgelegten Anzahl von Schaltvorgängen ausgebildet ist. Vorzugsweise wird bei erstmaliger Betätigung der Eingabetaste eine Kalibrierung bzw. Selbstkalibrierung des analogen Wegsensors vorgenommen. Dazu können die ersten manuellen Betätigungen oder eine bestimmte Anzahl von Betätigungen erfasst und ausgewertet werden. Anhand dieser erfassten Messwerte des analogen Wegsensors wird eine Kalibrierung vorgenommen, so dass Wegsignale des digitalen Wegsensors überwacht werden können.

Es liegt auch im Rahmen der Erfindung, dass für die Kalibrierung des analogen Wegsensors Grenzwerte für die Wegsignale, insbesondere die Spannungen, beim Einschalten und Ausschalten festgelegt sind, bei deren Über- oder Unterschreitung ein Fehlersignal durch die Auswerteeinheit ausgebbar ist. Diese Grenzwerte haben die Funktion einer "Kalibriergrenze", so dass Kalibrierwerte nur in einem festgelegten Wertebereich des analogen Wegsensors festgelegt werden können. Sofern durch die Auswerteeinheit ein Fehlersignal ausgegeben wird, kann dieses über einen Datenausgang und/oder einen Diagnoseausgang einer Auswerteeinheit oder an ein anderes Gerät übermittelt werden.

Gemäß einer Weiterbildung der Erfindung kann die Kalibriereinrichtung der elektrischen Eingabetaste zum Kalibrieren des analogen Wegsensors anhand einer statistischen Auswertung von Schaltvorgängen ausgebildet sein. Eine derartige statistische Auswertung kann während des Betriebs durchgeführt werden, wobei Differenzen der Schaltpunkte des analogen Wegsensors und des weiteren analogen oder eines digitalen Wegsensors erkannt werden können. Falls eine Drift der Schaltpunkte erkannt worden ist, können die Kalibrierwerte des analogen Wegsensors entsprechend angepasst werden.

Im Rahmen der Erfindung kann es auch vorgesehen sein, dass die Kalibrierung des analogen Wegsensors die Festlegung von Wertebereichen für die Wegsignale, insbesondere die Spannungen, beim Einschalten und Ausschalten anhand von kalibrierten Wegsignalen des digitalen Wegsensors umfasst. Somit werden bei der Kalibrierung zunächst z. B. Spannungen als Wegsignale des digitalen Wegsensors erfasst, auf dieser Basis werden Wertebereiche für die Wegsignale bzw. Spannungen des analogen Wegsensors beim Einschalten und Ausschalten festgelegt. Wenn bei der erfindungsgemäßen elektrischen Eingabetaste die Spannung des analogen Wegsensors außerhalb der Wertebereiche liegt, kann durch die Auswerteeinheit ein Fehlersignal ausgegeben werden.

Daneben betrifft die Erfindung ein Kraftfahrzeug. Das erfindungsgemäße Kraftfahrzeug zeichnet sich dadurch aus, dass es wenigstens eine elektrische Eingabetaste der beschriebenen Art aufweist.

Weitere Vorteile und Einzelheiten der Erfindung werden anhand eines Ausführungsbeispiels unter Bezugnahme auf die Zeichnungen erläutert. Die Zeichnungen sind schematische Darstellungen und zeigen:
- Fig. 1: eine geschnittene Ansicht einer erfindungsgemäßen elektrischen Eingabetaste; und
- Fig. 2: ein Diagramm, bei dem Spannungen als Wegsignale für einen analogen Wegsensor und einen digitalen Wegsensor aufgetragen sind.

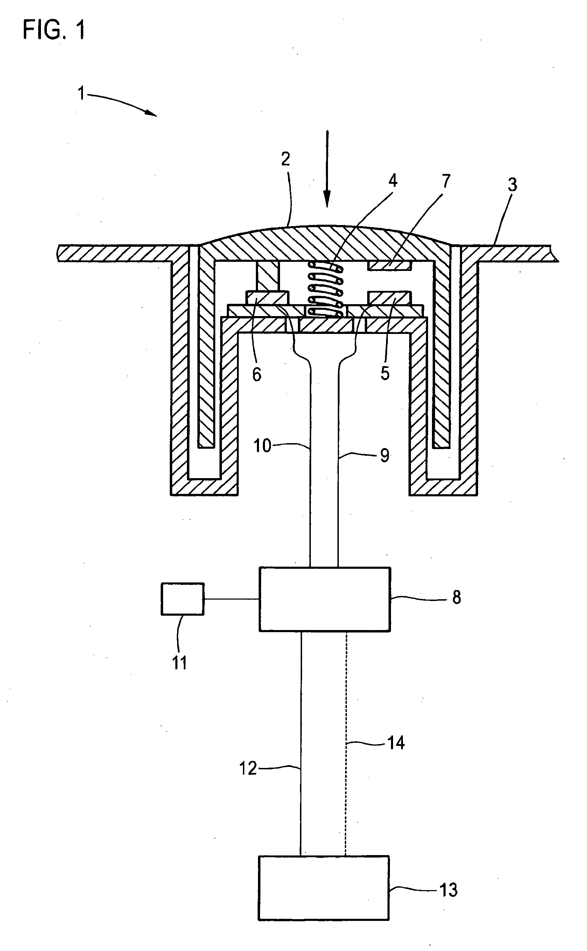

Die in Fig. 1 schematisch in einer geschnittenen Ansicht dargestellte elektrische Eingabetaste 1 umfasst eine Betätigungsfläche 2, die in einem Grundkörper 3 federnd gelagert ist. Beim Herunterdrücken der Betätigungsfläche 2 wird eine Spiralfeder 4 komprimiert, nach dem Loslassen der Spiralfeder 4 kehrt die Betätigungsfläche 2 selbsttätig in ihre Ausgangsstellung zurück.

Ferner umfasst die Eingabetaste 1 einen analogen Wegsensor 5 und einen digitalen Wegsensor 6. Es sind auch andere Ausführungsbeispiele möglich, bei denen zwei analoge Wegsensoren oder mehr als zwei Wegsensoren verwendet werden. Grundsätzlich umfasst die Eingabetaste wenigstens einen analogen Wegsensor und wenigstens einen weiteren Wegsensor (analog oder digital).

In dem dargestellten Ausführungsbeispiel ist der analoge Wegsensor 5 ein induktiver Sensor, der mit einem Magnet 7 zusammenwirkt. Bei einer Verschiebung der Betätigungsfläche 2 nähert sich der Magnet 7 dem analogen Wegsensor 5 an, wodurch eine Spannung als Wegsignal erzeugt wird. Diese Spannung wird einer Auswerteeinheit 8 zugeführt. In derselben Weise erzeugt der digitale Wegsensor 6 bei einer Verschiebung der Betätigungsfläche 2 eine Spannung als Wegsignal, die ebenfalls der Auswerteeinheit 8 zugeführt wird. Die Auswerteeinheit 8 ist über eine Leitung mit einer Kalibriereinrichtung 11 verbunden, die zur Kalibrierung dient.

Über eine Ausgangssignalleitung 12 ist die Auswerteeinheit 8 mit einem Gerät 13 verbunden, das unterschiedliche Aufgaben übernehmen kann. Dazu zählt die Speicherung von Fehlerdaten, die Weiterleitung der ausgewerteten Wegsignale an andere Geräte oder eine Umprogrammierung der Auswerteeinheit 8, für diesen Zweck ist zusätzlich eine Diagnose- und Programmiersignalleitung 14 vorgesehen, die die Auswerteeinheit 8 mit dem Gerät 13 verbindet. Die Leitung 14 kann jedoch auch in die Ausgangssignalleitung 12 integriert sein.

Der analoge Wegsensor 5 und der digitale Wegsensor 6 der elektrischen Eingabetaste 1 sind derart zwischen der Unterseite der Betätigungsfläche 2 und einer Auflagefläche des Grundkörpers 3 angeordnet, dass sich ihr Messweg im Wesentlichen synchron mit der Betätigung der Betätigungsfläche 2 verändert. Die Auswerteeinheit 8 diagnostiziert die beiden von den Wegsensoren 5, 6 erzeugten Spannungssignale und gibt über die Ausgangssignalleitung 12 den ermittelten Schaltzustand der Eingabetaste 1 aus. Bei erstmaliger Betätigung der elektrischen Eingabetaste 1 wird zunächst eine Kalibrierung des analogen Wegsensors 5 durchgeführt. Bei der ersten Betätigung werden diejenigen Messwerte des analogen Wegsensors 5 ermittelt, die den Schaltpunkten des digitalen Wegsensors 6 entsprechen.

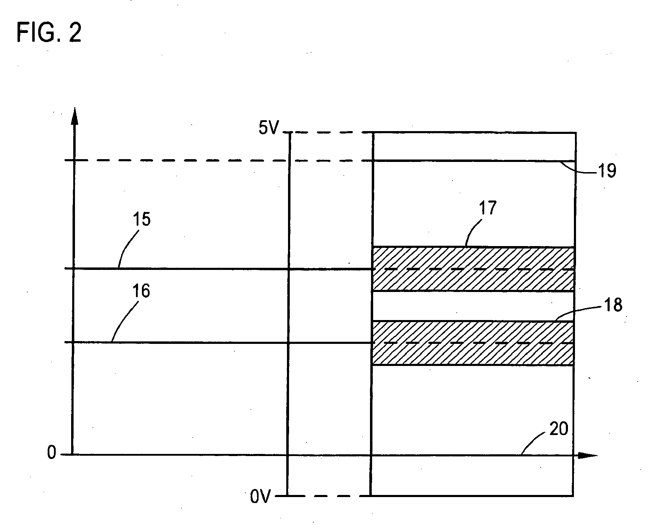

In dem Diagramm von Fig. 2 kennzeichnet die Linie 15 den kalibrierten Einschaltpunkt des digitalen Wegsensors 6. Die Linie 16 kennzeichnet den kalibrierten Ausschaltpunkt des digitalen Wegsensors 6. Der Einschaltpunkt und der Ausschaltpunkt des digitalen Wegsensors 6 entsprechen bestimmten Spannungen. Der analoge Wegsensor 5 wird entsprechend dem Einschaltpunkt und dem Ausschaltpunkt des digitalen Wegsensors 6 kalibriert. Für den analogen Wegsensor 5 wird um den Einschaltpunkt herum ein zulässiger Messwertebereich 17 gebildet. Dieser Wertebereich, der durch eine untere Spannung und eine obere Spannung begrenzt wird, entspricht einem Toleranzbereich für zulässige Schaltvorgänge, bei denen die Eingabetaste 1 eingeschaltet wird. In ähnlicher Weise wird um den kalibrierten Ausschaltpunkt ein zulässiger Messwertebereich 18 definiert, der zulässige Spannungswerte beim Ausschalten der elektrischen Eingabetaste 1 definiert. In dem Spannungsbereich zwischen den Wertebereichen 17, 18 darf kein Schaltvorgang stattfinden.

Falls die Spannung des analogen Wegsensors 5 eine obere Grenze 19 überschreitet, wird dies als Fehler des analogen Sensors interpretiert. Dasselbe gilt sinngemäß bei einer Unterschreitung einer unteren Grenze 20.

Nach der am Anfang erfolgten Kalibrierung vergleicht die Auswerteeinheit 8 im weiteren Betrieb die Spannungssignale des analogen Wegsensors und des digitalen Wegsensors. Bei fehlender Übereinstimmung oder zu großen Abweichungen der Messwerte der beiden Sensorsysteme voneinander oder bei unplausiblen Messwerten des analogen Wegsensors werden Fehlermeldungen ausgegeben.

Die in Fig. 1 gezeigte elektrische Eingabetaste 1 ist so ausgebildet, dass eine Selbstkalibrierung auch während des Betriebs durchgeführt wird. Dazu wird die Differenz der Schaltpunkte des analogen Wegsensors 5 und des digitalen Wegsensors 6 statistisch ausgewertet. Falls es im Laufe der Lebensdauer zu einer Drift der Schaltpunkte kommt, erfolgt eine neue Kalibrierung, um die Schaltpunkte des digitalen Wegsensors 6 mit denen des analogen Wegsensors 5 in Übereinstimmung zu bringen.

Die Überwachung und Diagnose der von den beiden Sensoren gelieferten Signalwerte erfolgt fortlaufend, wenn im Rahmen der Diagnose ein Fehler erkannt wird, können die folgenden Daten über die Ausgangssignalleitung 12 oder die Diagnose- und Programmierleitung 14 ausgegeben werden: die aktuellen Kalibrierwerte, das heißt die den Einschalt- und Ausschaltpunkten entsprechenden Spannungen, die über das analoge Sensorsystem ermittelten Schaltpunkte des digitalen Sensorsystems und die ermittelte Abweichung der Schaltpunkte des digitalen Sensorsystems von den Kalibrierwerten des analogen Sensorsystems.

Die elektrische Eingabetaste umfasst einen Diagnose- und/oder Kalibriermodus, in dem alle aktuellen Mess- und Kalibrierwerte ausgegeben werden und in dem eine gezielte Neukalibrierung durchgeführt werden kann.

Die wesentlichen Systemkomponenten der Eingabetaste, nämlich die Betätigungsfläche, der analoge Wegsensor und der digitale Wegsensor sowie die Auswerteeinheit und die Kalibriereinheit müssen nicht notwendigerweise getrennt ausgebildet sein, mehrere Systemkomponenten können zu Baugruppen zusammengefasst werden.

Die Erfindung ist nicht auf das dargestellte Ausführungsbeispiel beschränkt, insbesondere sind auch Ausführungen möglich, bei denen zwei analoge Wegsensoren vorgesehen sind. Durch einen analogen Wegsensor werden die Schaltpunkte festgelegt, anhand dieser Schaltpunkte wird der andere analoge Wegsensor kalibriert.

## Patentansprüche

1. Elektrische Eingabetaste (1), mit einer Betätigungsfläche (2) und mehreren Wegsensoren (5, 6), die jeweils zur Erzeugung eines Wegsignals bei einer Berührung der Betätigungsfläche ausgebildet sind, sowie einer Auswerteeinheit (8) zum Auswerten der Wegsignale und zum Ausgeben eines ermittelten Schaltzustands,
**dadurch gekennzeichnet,**
**dass** die Eingabetaste (1) wenigstens einen analogen Wegsensor (5) und wenigstens einen digitalen Wegsensor (6) umfasst, sowie eine Kalibriereinrichtung (11) zum Kalibrieren des analogen Wegsensors (5) anhand von erfassten Wegsignalen des digitalen Wegsensors (6), wobei die Auswerteeinheit (8) zur Durchführung einer Eigendiagnose anhand kalibrierter und erfasster Wegsignale ausgebildet ist.

2. Elektrische Eingabetaste nach Anspruch 1,
**dadurch gekennzeichnet,**
**dass** ein digitaler Wegsensor (6) als Mikroschalter oder als digitaler Hall-Sensor oder als digitaler magnetoresistiver Sensor ausgebildet ist.

3. Elektrische Eingabetaste nach Anspruch 1 oder 2,
**dadurch gekennzeichnet,**
**dass** der wenigstens eine analoge Wegsensor (5) als induktiver Sensor oder als kapazitiver Sensor oder als analoger Hall-Sensor oder als analoger magnetoresistiver Sensor ausgebildet ist.

4. Elektrische Eingabetaste nach einem der vorangehenden Ansprüche,
**dadurch gekennzeichnet,**
**dass** die Kalibriereinrichtung (11) zum Kalibrieren des analogen Wegsensors (5) bei erstmaliger Berührung der Betätigungsfläche (2) und/oder nach einer festgelegten Anzahl von Schaltvorgängen ausgebildet ist.

5. Elektrische Eingabetaste nach einem der vorangehenden Ansprüche,
**dadurch gekennzeichnet,**
**dass** für die Kalibrierung des analogen Wegsensors (5) Grenzwerte (19, 20) für die Wegsignale beim Einschalten und Ausschalten festgelegt sind, bei deren Über- oder Unterschreitung ein Fehlersignal durch die Auswerteeinheit (8) ausgebbar ist.

6. Elektrische Eingabetaste nach einem der vorangehenden Ansprüche,
**dadurch gekennzeichnet,**
**dass** die Kalibriereinrichtung (11) zum Kalibrieren des analogen Wegsensors (5) anhand einer statistischen Auswertung von Schaltvorgängen ausgebildet ist.

7. Elektrische Eingabetaste nach einem der vorangehenden Ansprüche,
**dadurch gekennzeichnet,**
**dass** die Kalibrierung des analogen Wegsensors (5) die Festlegung von Wertebereichen (17, 18) fur die Wegsignale beim Einschalten und Ausschalten anhand von kalibrierten Wegsignalen des digitalen Wegsensors (6) umfasst.

8. Elektrische Eingabetaste nach Anspruch 7,
**dadurch gekennzeichnet,**
**dass** die Auswerteeinheit (8) bei einem außerhalb der Wertebereiche (17, 18) liegenden Wegsignal des analogen Wegsensors (5) zum Ausgeben eines Fehlersignals ausgebildet ist.

9. Elektrische Eingabetaste nach einem der vorangehenden Ansprüche,
**dadurch gekennzeichnet,**
**dass** das analoge Wegsignal eine Spannung, ein Strom, eine Kapazität oder eine Magnetfeldstärke ist.

10. Kraftfahrzeug,
**dadurch gekennzeichnet,**
**dass** es wenigstens eine elektrische Eingabetaste (1) nach einem der Patentansprüche 1 bis 9 aufweist.

## Claims

1. Electric input key (1) comprising an actuating surface (2) and a plurality of displacement sensors (5, 6), each of which is configured for generating a displacement signal when the actuating surface is touched, and an evaluation unit (8) for evaluating the displacement signals and for outputting a determined switching state, **characterised in that** the input key (1) comprises at least one analogue displacement sensor (5) and at least one digital sensor (6), and a calibration device (11) for calibrating the analogue displacement sensor (5) using recorded displacement signals from the digital displacement sensor (6), the evaluation unit (8) being configured for carrying out a self-diagnosis using calibrated and recorded displacement signals.

2. Electric input key according to claim 1, **characterised in that** a digital displacement sensor (6) is in the form of a microswitch, a digital Hall-effect sensor, or a digital magnetoresistive sensor.

3. Electric input key according to either claim 1 or claim 2, **characterised in that** the at least one analogue displacement sensor (5) is in the form of an inductive sensor, or a capacitive sensor, or an analogue Hall-effect sensor, or an analogue magnetoresistive sensor.

4. Electric input key according to any of the preceding claims, **characterised in that** the calibration device (11) is configured for calibrating the analogue displacement sensor (5) when the actuating surface (2) is touched for a first time and/or after a predetermined number of switching operations.

5. Electric input key according to any of the preceding claims, **characterised in that** for calibrating the analogue displacement sensor (5), limit values (19, 20) for the displacement signals are predetermined during switch-on and switch-off, it being possible for the evaluation unit (8) to emit an error signal if said limit values are exceeded or if the values fall below said limit values.

6. Electric input key according to any of the preceding claims, **characterised in that** the calibration device (11) is configured for calibrating the analogue displacement sensor (5) using a statistical evaluation of switching operations.

7. Electric input key according to any of the preceding claims, **characterised in that** calibration of the analogue displacement sensor (5) includes determining value ranges (17, 18) for the displacement signals during switch-on and switch-off using calibrated displacement signals from the digital displacement sensor (6).

8. Electric input key according to claim 7, **characterised in that** the evaluation unit (8) is configured to emit an error signal if a displacement signal from the analogue displacement sensor (5) lies outside the value range (17, 18).

9. Electric input key according to any of the preceding claims, **characterised in that** the analogue displacement signal is a voltage, a current, a capacitance, or a magnetic field strength.

10. Motor vehicle, **characterised in that** it comprises at least one electric input key (1) according to any of claims 1 to 9.

## Revendications

1. Touche d'entrée électrique (1) comprenant une surface de commande (2) et plusieurs capteurs de position (5, 6), qui sont conçus pour générer un signal de position lors d'un contact de la surface de commande, ainsi qu'une unité d'exploitation (8) pour exploiter les signaux de position et délivrer un état de commutation déterminé,
**caractérisée en ce que** :
la touche d'entrée (1) comprend au moins un capteur de position analogique (5) et au moins un capteur de position numérique (6), ainsi qu'un dispositif d'étalonnage (11) pour étalonner le capteur de position analogique (5) sur la base de signaux de position détectés du capteur de position numérique (6), dans laquelle l'unité d'exploitation (8) est conçue pour réaliser un autodiagnostic sur la base de signaux de position étalonnés et détectés.

2. Touche d'entrée électrique selon la revendication 1,
**caractérisée en ce que** :
un capteur de position numérique (6) se présente sous la forme d'un microrupteur ou d'un capteur de Hall numérique ou encore d'un capteur magnétorésistif numérique.

3. Touche d'entrée électrique selon la revendication 1 ou la revendication 2,
**caractérisée en ce que** :
le au moins un capteur de position analogique (5) se présente sous la forme d'un capteur inductif ou d'un capteur capacitif ou encore d'un capteur de Hall analogique ou d'un capteur magnétorésistif analogique.

4. Touche d'entrée électrique selon l'une quelconque des revendications précédentes,
**caractérisée en ce que** :
le dispositif d'étalonnage (11) est conçu pour étalonner le capteur de position analogique (5) lors du premier contact de la surface de commande (2) et/ou après un nombre fixe d'opérations de commutation.

5. Touche d'entrée électrique selon l'une quelconque des revendications précédentes,
**caractérisée en ce que** :
pour l'étalonnage du capteur de position analogique (5), on fixe des valeurs limites (19, 20) pour les signaux de position lors de la connexion et de la déconnexion et, lors d'un dépassement par le haut ou par le bas, un signal d'erreur peut être affiché par l'unité d'exploitation (8).

6. Touche d'entrée électrique selon l'une quelconque des revendications précédentes,
**caractérisée en ce que** :
le dispositif d'étalonnage (11) est conçu pour étalonner le capteur de position analogique (5) sur la base d'une exploitation statistique d'opérations de commutation.

7. Touche d'entrée électrique selon l'une quelconque des revendications précédentes,
**caractérisée en ce que** :
l'étalonnage du capteur de position analogique (5) comprend la fixation de plages de valeurs (17, 18) pour les signaux de position lors de la connexion et de la déconnexion sur la base de signaux de position étalonnés du capteur de position numérique (6).

8. Touche d'entrée électrique selon la revendication 7,
**caractérisée en ce que** :
l'unité d'exploitation (8) est conçue pour, lorsqu'un signal de position du capteur de position analogique (5) se trouve en dehors des plages de valeurs (17, 18), délivrer un signal d'erreur.

9. Touche d'entrée électrique selon l'une quelconque des revendications précédentes,
**caractérisée en ce que** :
le signal de position analogique est une tension, un courant, une capacité ou une intensité de champ magnétique.

10. Véhicule automobile,
**caractérisé en ce que** :
il présente au moins une touche d'entrée électrique (1) selon l'une quelconque des revendications 1 à 9.
